# EUROPEAN PATENT SPECIFICATION

(11) **EP 2 865 021 B1**
(45) Date of publication and mention of the grant of the patent: **01.02.2017**
(21) Application number: 13729948.3
(22) Date of filing: 18.06.2013
(51) Int. Cl.: H01L 33/38, H01L 27/15, H01L 33/20, H01L 33/62, H01L 31/02, H01L 31/075, H01L 31/18

(54) **METHOD OF COLLECTIVE MANUFACTURE OF LEDS AND STRUCTURE FOR COLLECTIVE MANUFACTURE OF LEDS.**
VERFAHREN ZUR KOLLEKTIVEN HERSTELLUNG VON LEUCHTDIODEN UND STRUKTUR ZUR KOLLEKTIVEN HERSTELLUNG VON LEUCHTDIODEN
PROCÉDÉ ET STRUCTURE DE FABRICATION COLLECTIVE DE DEL

(30) Priority: 22.06.2012 FR 1255931; 22.06.2012 FR 1255934
(43) Date of publication of application: 29.04.2015
(73) Proprietor: Soitec, 38190 Bernin (FR)
(72) Inventor: GUENARD, Pascal, F-38190 Froges (FR)
(74) Representative: IP Trust
(86) International application number: PCT/EP2013/062658
(87) International publication number: WO 2013/189949

(56) References cited:
- EP-A1- 2 390 933
- US-A1- 2005 280 007
- US-A1- 2006 169 994
- US-A1- 2008 179 602
- US-A1- 2012 074 441
- US-B1- 6 281 524

## Description

### Technical field and prior art

The present invention relates to the manufacture of light-emitting diodes (LEDs).

LEDs are generally manufactured from elemental structures corresponding to a stack of layers comprising at least one n-type layer or region, a p-type layer or region and an active layer disposed between the n-type and p-type layers. These elemental LED structures can be formed from the same growth substrate on which a stack of the layers described above is formed by epitaxial growth, portions of this stack then being cut out of the substrate to form each an elemental LED structure.

However, other LED manufacturing operations -such as wiring of the LED by formation of n- and p-type contact pads or disassembly/removal of the growth support notably required to carry out treatments in the case of high-intensity LEDs-are carried out all or in part on the level of each LED individually, meaning that the elemental structures are separate from each other and that one structure is thus dealt with at a time.

The same is true for operations involved in the assembly of LEDs on a mechanical support and operations of deposition of a light-converting material ("phosphorus"), which are carried out individually for each LED. Although carrying out these operations individually allows good control of the precision of the LED manufacturing process, it multiplies the number of operations by the number of LEDs to be manufactured and consequently increases LED manufacturing costs. Some LED fabrication processes are also known from documents EP2390933, US2012/074441 and US2008/179602.

### Summary of the invention

The aim of the invention is to remedy notably the disadvantages mentioned above by allowing a collective manufacture of LEDs.

This aim is achieved with a method of collective manufacturing of light-emitting diode (LED) devices comprising formation on a surface of a first substrate of a plurality of elemental LED structures each comprising at least one n-type layer, an active layer and a p-type layer, the elemental LED structures being spaced apart from each other on the first substrate by trenches, the method further comprising:
- reduction of the lateral dimensions of the p-type layer, the active layer and a first part of the n-type layer in contact with the active layer, the n-type layer having a second part with lateral dimensions larger than the first part of the n-type layer;
- deposition of an insulating material layer on at least each elemental structure;
- formation of a portion of insulating material on the sides of the p-type layer, the active layer and the first part of the n-type layer;
- formation of n-type electrical contact pads on at least the whole of the second part of the exposed n-type layer;
- formation of p-type electrical contact pads before or after the lateral dimension reduction step;
- deposition of a conductive material layer on the whole of the surface of the first substrate comprising the elemental LED structures and polishing of the conductive material layer, polishing being carried out until reaching at least the part of the insulating material layer present between the p- and n-type electrical contact pads so as to form a structure comprising individual portions of conductive material layer, each individual portion being in contact with one or more n-type electrical contact pads; and
- bonding by molecular adhesion of a second substrate on the polished surface of said structure.

Thus, the inventive method makes it possible to form collectively n-type contact pads and p-type contact pads for the whole of the elemental structures present on the substrate. The number of operations required to form the contact pads is here considerably fewer in relation to the prior art wherein contact pads are formed independently on each elemental structure. One thus has a substrate or plate comprising a plurality of wired elemental structures that can be cut out individually or as a group to form LED devices.

The invention advantageously makes it possible to form n-and p-type contact pads and to assemble the substrate comprising the elemental LED structures with a transfer substrate, all in a minimum of steps, thus making it possible to reduce costs and production times.

In a particular embodiment, the n- and p-type contact pads are prepared simultaneously during the same step in which a metal layer is deposited on the whole of the elemental structures.

In a particular embodiment, the insulating material layer is further deposited in a part of the trenches present between the elemental LED structures, the trenches free of insulating material delimiting cutting zones around the elemental LED structures.

In a particular embodiment, each elemental LED structure is formed on an island of relaxed or partially relaxed material.

The relaxed or partially relaxed material is InGaN, for example.

In a particular embodiment, the method includes, after bonding of the second substrate, removal of the first substrate.

The initial substrate, notably making it possible to free the light-emitting surface of the LED devices, is removed in a single operation for the whole of the elemental structures. In certain cases, the substrate once removed can also be recycled and used again one or more times.

The method can further include deposition of a light-converting material layer on the surface of the elemental LED structures exposed after removal of the first substrate.

One thus has a structure from which can be cut out LED devices each formed of one or more wired elemental structures, provided with a final substrate and covered with a light-converting layer.

In a particular embodiment, the method includes formation of microstructures on the surface of the elemental LED structures exposed after removal of the first substrate.

One thus has a structure from which can be cut out LED devices each formed of one or more wired elemental structures, provided with a final substrate and microstructures notably making it possible to confer particular optical properties on the LED devices.

In a particular embodiment, the second substrate comprises on its bonding surface a plurality of electrical contact pads disposed with positions of alignment with the individual portions of the conductive material layer or with the p-type contact pads.

The LED devices can thus be powered and controlled from the second substrate.

In a particular embodiment, formation of n-type contact pads comprises deposition of a conductive material layer of determined thickness on the whole of the surface of the first substrate comprising the elemental LED structures.

In a particular embodiment, the method further includes, after deposition of the conductive material layer, directive etching of the conductive material layer so as to allow portions of the conductive material layer to remain on the lateral walls of the elemental structures, said portions forming the n-type contact pads.

In a particular embodiment, the method includes, after the selective (or directive) etching step, formation of openings at a limited depth in the p-type layer of each elemental LED structure and filling of these openings with a conductive material so as to form a p-type contact pad.

Correspondingly, the invention relates to a structure for the collective manufacture of light-emitting diode (LED) devices comprising a first substrate including on a surface a plurality of elemental LED structures each comprising at least one n-type layer, an active layer and a p-type layer, the elemental structures being spaced apart from each other on the first substrate by trenches, each elemental LED structure comprising:
- a first part comprising the p-type layer, the active layer and a first part of the n-type layer in contact with the active layer and a second part comprising a second part of the n-type layer, the first part of each elemental LED structure having lateral dimensions less than the second part of each elemental LED structure;
- a part of insulating material on the sides of the p-type layer, the active layer and the first part of the n-type layer;
- an n-type electrical contact pad on at least the whole of the second part of the exposed n-type layer; and
- p-type electrical contact pads;
the structure further comprising, on its side opposite that comprising the first substrate, a planar surface comprising individual portions of conductive material each respectively in contact with an n-type electrical contact pad, the individual portions of the layers of conductive material being separated by portions of the insulating material layer,
a second substrate (50) being bonded on said planar surface of the structure.

In a particular embodiment, the second substrate comprises on its side bonded to the structure a series of contact pads separated from each other by portions of insulating material,
the pads of the series of contact pads being connected with the n- and p-type electrical contact pads of the elemental structures.

In a particular embodiment, the structure further comprises a light-converting material layer on the n-type layer of the elemental LED structures.

In a particular embodiment, the structure further comprises microstructures present on the n-type layer of the elemental LED structures.

### Brief description of the figures

- figures 1A to 1O are schematic perspective and cross-sectional views showing the collective manufacture of LED devices in accordance with an embodiment of the invention,
- figures 2A and 2B are flow diagrams of the steps implemented in figures 1A to 1O,
- figures 3A to 3E are schematic perspective and cross-sectional views showing a variant embodiment of n-type contact pads in accordance with an embodiment of the invention,
- figure 4 is a flow diagram of the steps implemented in figures 3A to 3E,
- figures 5A to 5E are schematic perspective and cross-sectional views showing a variant embodiment of p-type contact pads in accordance with an embodiment of the invention,
- figure 6 is a flow diagram of the steps implemented in figures 5A to 5E,
- figures 7A to 7C are schematic perspective and cross-sectional views showing a variant embodiment of p-type contact pads in accordance with an embodiment of the invention, and
- figure 8 is a flow diagram of the steps implemented in figures 7A to 7C.

### Detailed description of the embodiments of the invention

The present invention applies to the collective manufacture of light-emitting diode (LED) devices. As explained in detail below, the invention allows the collective manufacture on a plate of LED devices each comprising at least one or more elemental LED structures which, at different stages of the process, are further provided with one or more of the following elements:
- p-type contacts,
- n-type contacts,
- a final substrate provided with vertical electronic connections (vias) for access to the contacts, the final substrate being further able to be provided with electronic circuits,
- a light-converting material layer,
- microstructures, in particular optical microstructures.

All of the elements mentioned above can be prepared collectively as in the example described below, i.e., during the same operations carried out on the whole of the elemental LED structures present on the plate. However, if need be, the LED devices can be cut out at an intermediate stage of the collective manufacturing method, for example after formation of the p- and n-type contacts, and then processed individually in subsequent manufacturing steps. According to needs, in particular in terms of light intensity, an LED device cut from the plate will be able to include several elemental LED structures connected in series or in parallel.

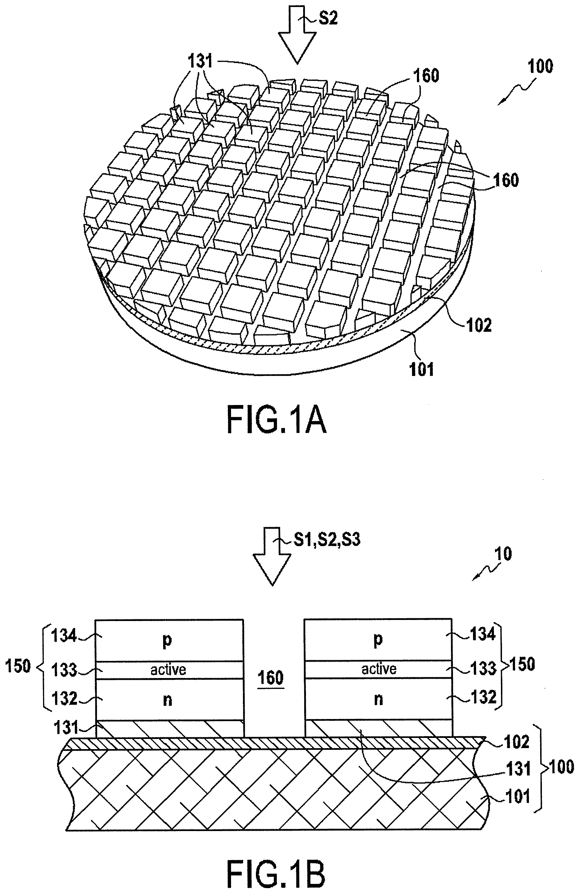

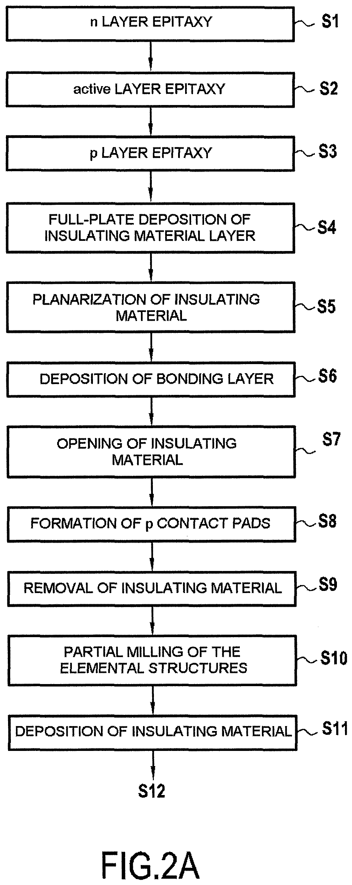

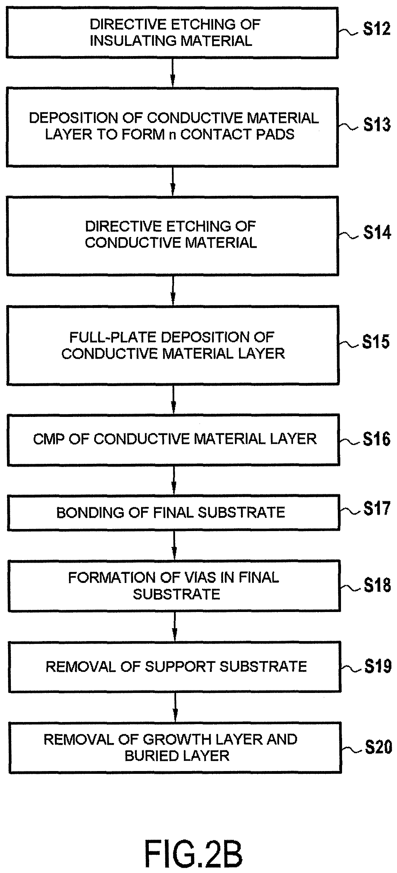

A method of collective manufacturing of LEDs is described in reference to figures 1A to 1O and 2A and 2B.

In the example described here, the method is implemented from plate or composite growth substrate 100 comprising support substrate 101, buried layer 102 and growth islands 103 (figure 1A). Support substrate 101 consists here of sapphire. Substrate 101 can also be composed of a semiconductor material such as notably silicon, silicon carbide or germanium. The buried layer is a bonding layer prepared here in SiO₂. Growth islands 103 are obtained from a growth layer of strained material, here an InGaN layer prepared, for example, by epitaxial growth on a GaN germ layer and transferred on support substrate 101 via buried layer 102.

Trenches 160 were made in the growth layer so as to delimit InGaN growth islands 131. These trenches also made it possible to relax the strained material of the growth layer. As a nonrestrictive example, each island 131 has here a square shape with sides 1 mm in length. The shape and dimensions of the islands, which define the shape and at least part of the dimensions of the final LEDs, can obviously be different, with the islands notably being able to have a circular shape.

The method begins with formation by epitaxy of n-type layer 132 (about 1 µm in thickness), active layer 133 (about 10 nm) and p-type layer 134 (about between 100 nm and 200 nm in thickness) on each island 131 by epitaxy (steps S1, S2, S3, figure 1B), these three layers forming on each island elemental LED structure 150. At this stage of the process, one has structure 10 in the form of a plate and which comprises on its upper surface a plurality of LED structures 150 separated from each other by trenches 160.

The n- and p-type layers can be formed in the reverse order (p-type layer closest to islands 131) and include several layers of different compositions, thicknesses or dopant concentrations, comprising unintentionally doped layers.

Active layer 133 is a light-emitting layer which can be formed of a single thick or thin layer or of a plurality of layers of light-emitting quantum wells separated from each other by barrier layers.

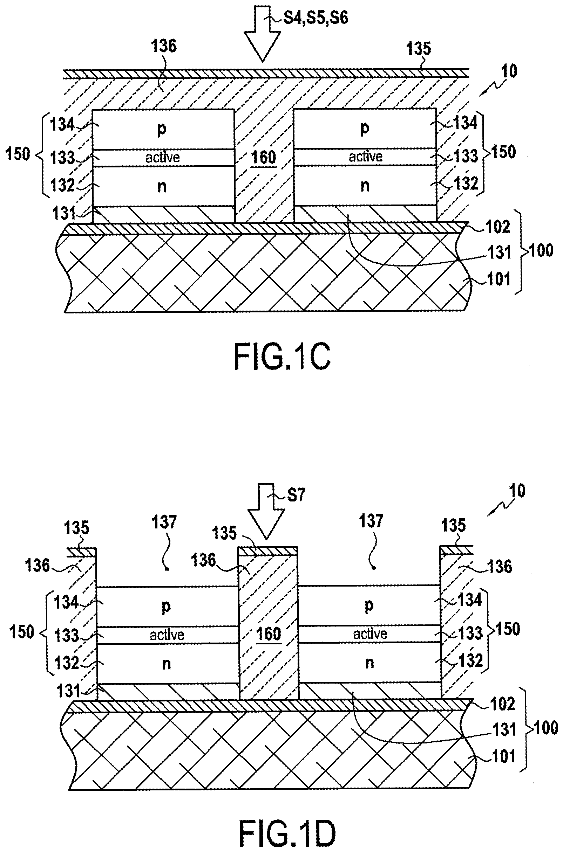

Insulating material layer 136, here SiO₂, is deposited by plasma-enhanced chemical vapor deposition (PECVD) on the whole of the upper surface of structure 10 comprising elemental structures 150, layer 136 covering both the elemental structures 150 and trenches 160 (step S4, figure 1C). After deposition, insulating material layer 136 is planarized by chemical-mechanical polishing (CMP) or etching (step S5, figure 1C). SiO₂ layer 136 can also be formed by the well-known spin-on glass (SOG) technique, which consists in depositing, on the substrate in rotation on a spinner, a viscous SiO₂ precursor composition. With this deposition technique, the SiO₂ layer has a satisfactory surface quality that does not require post-deposition planarization.

According to an aspect of the invention, certain trenches 160 are not filled with insulating material 136 in order to facilitate cutting of the structure into a plurality of blocks each comprising one or more LED structures. The trenches free of insulating material thus delimit cutting zones around the elemental structures.

Adhesion layer 135, for example a titanium layer about 10 nm in thickness, can be formed on insulating material layer 160 in order to facilitate adhesion of the structure with certain metals that adhere with difficulty on SiO₂ (step S6, figure 1C).

Layers 135 and 136 are then opened, for example by dry or wet selective chemical etching, on p-type layer 134 (step S7, figure 1D). In the example described here, openings 137 are formed in layer 136 on top of each p-type layer 134. To this end, use is made of an etching mask comprising a protective resin layer with openings (resin-free zones) delimiting the zones to be etched in the structure.

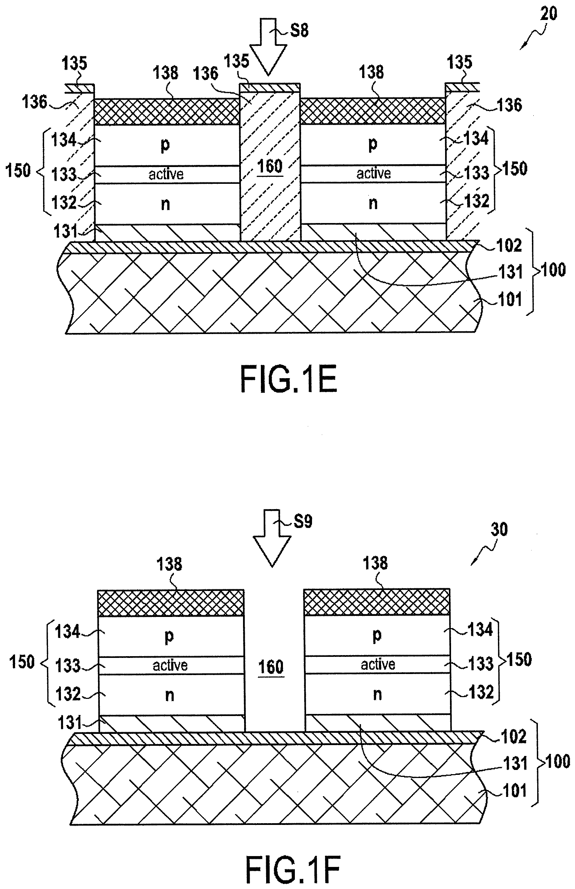

p-type contact pads 138 are formed in openings 137 by deposition in the latter of at least one conductive material (step S8, figure 1E). During deposition of the materials for contact pads 138, the mask used is preserved for etching openings 137. Once p-type contact pads 138 are formed, the protective resin of the etching mask is removed, which makes it possible to remove at the same time the constitutive materials of p-type contact pads 138 deposited beyond openings 137.

The layer forming p-type contact pads 138 can notably include:
- a metal such as Ni, Pd or Pt with a thickness between 1 Å and 5 nm, in order to obtain a good resistivity and a good ohmic character,
- a reflector, for example in the form of a layer of Ag with a thickness of about 100 nm, in order to return to the emitting surface the photons leaving toward the opposite surface (i.e., those moving toward the p-type layer when the structure is transferred to the final substrate, the emitting surface thus being found on the side of n-type layer 132), and
- a diffusion barrier, for example in the form of a layer of WN or TiN with a thickness between 20 and 50 nm.

Formation of insulating material layer 136 on the whole of elemental structures 150 makes it possible to form collectively, i.e., in one operation for all structures 150, p-type contact pads 138.

At this stage of the process, one already has structure 20 in the form of a plate with a plurality of elemental structures 150 each provided with a p-type contact pad. Structure 20 can be cut out in a plurality of devices each comprising one or more elemental structures 150 according to the final application envisaged, the remaining LED formation operations, such as formation of n-type contact pads, being carried out individually for each device cut out.

In the example described here, the method continues with the preparation of n-type contact pads comprising the opening or removal, for example by chemical etching, of insulating material layer 136 present on the lateral surfaces of elemental structures 150 and in trenches 160 (step S9, figure 1F). At this stage of the process one also has structure 30 in the form of a plate with a plurality of elemental structures 150 each provided with a p-type contact pad capable of forming alone or in multiples after cutting from the structure a plurality of devices.

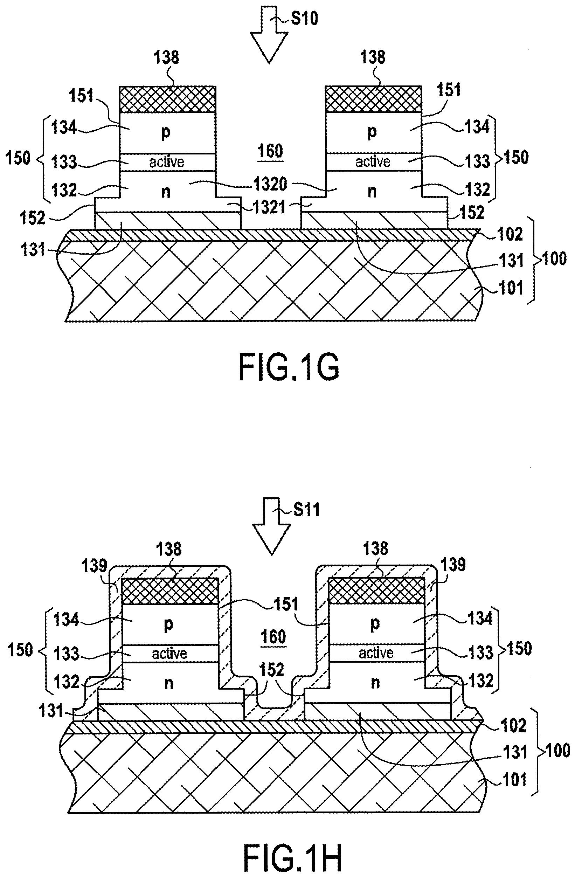

One then proceeds with milling, for example by chemical etching or dry etching, for example reactive-ion etching (RIE), of a lateral portion of elemental structures 150 over a determined width from the lateral margin of each structure and to a determined depth in n-type layer 132 so as to form in each elemental structure 150 a milled portion 151 having reduced lateral dimensions (width, diameter, etc.), this milled portion comprising layers 134 and 133 as well as a first part 1320 of layer 132 in contact with active layer 133 (step S10, figure 1G). One thus forms in each elemental structure 150 a first portion 151 having reduced lateral dimensions (width, diameter, etc.) in relation to a second underlying portion 152 comprising the remaining part 1321 of unmilled layer 132.

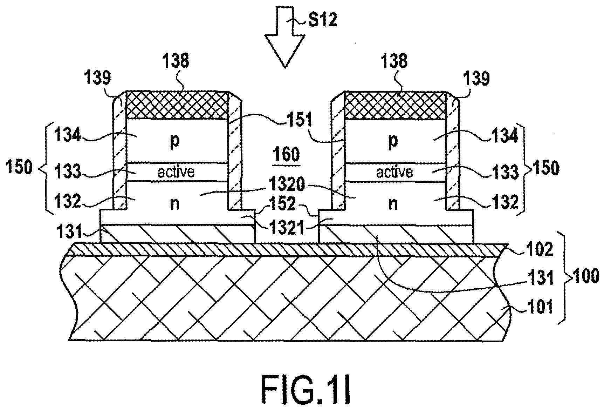

After milling, one proceeds to full-plate deposition of thin insulating material layer 139, for example SiO₂ (step S11, figure 1H). The thickness of the insulating material layer is limited so as to follow the contours of elemental LED structures 150 and trenches 160. This deposition is followed by directive dry etching that preferentially etches in the vertical direction so as to open insulating material layer 139 on the surface of p-type contact pads 138 and n-type layer 132 present on unmilled portion 152. After dry etching, layer 139 remains only on the sides of elemental structures 150 on milled portion 151 (step S12, figure 1I).

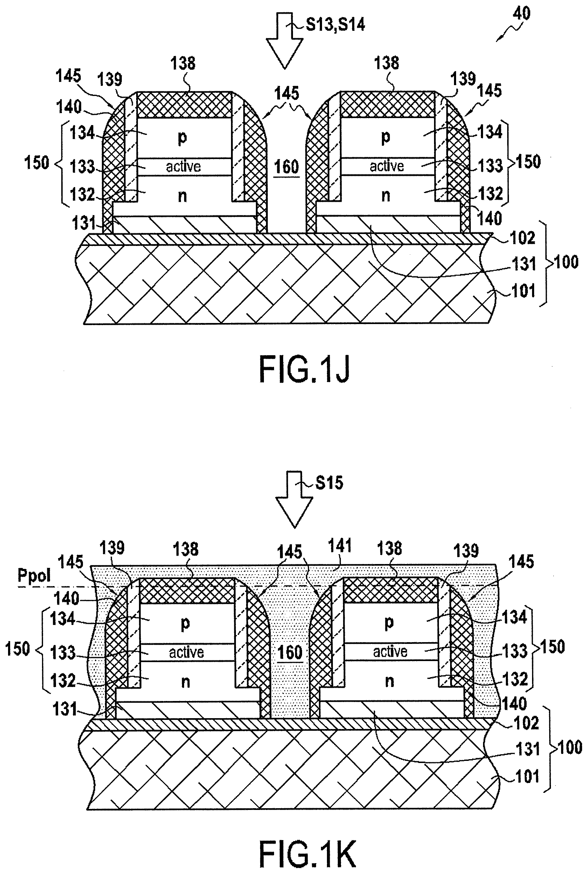

One then carries out deposition of conductive material layer 140, for example Ti/Al/Ni, followed by directive dry etching that preferentially etches in the vertical direction so as to leave layer 140 remaining on the lateral walls of elemental structures 150 (steps S13 and S14, figure 1J). Conductive material layer 140 is in contact with the lateral wall of n-type layer 132 present on unmilled portion 152 of elemental structures 150 and is capable of forming n-type contact pads 145.

Thanks to the prior deposition of insulating material layer 139 for protecting the part of each elemental structure located above the unmilled portion of layer 132, the conductive material layer 140 intended to form n-type contact pads 145 can be deposited in an overall fashion (i.e., in a single operation) on the whole of the plate, which allows a collective preparation of n-type contact pads for each LED.

At this stage of the process, one has structure 40 in the form of a plate with a plurality of elemental structures 150 each provided with a p-type contact pad and an n-type contact pad, structure 40 being able to be cut into a plurality of devices each comprising one or more elemental structures 150 according to the final application envisaged, the remaining LED formation operations being carried out individually for each device cut out.

In the example described here, conductive material layer 140 is present only on the lateral walls of elemental structures 150. According to a variant embodiment, the conductive material layer can entirely fill trenches 160. In the second case, the n-type layers 132 of the adjacent elemental structures are connected.

According to still another variant embodiment, the space present in the trenches between two portions of conductive material can be filled with an insulating material.

In all these variant embodiments, conductive material layer 140 is in contact with the entire lateral wall of the n-type layer 132 exposed on unmilled portion 152. One thus creates contact with a large surface, which makes it possible to significantly reduce electrical resistance at the n-type contact pad without really penalizing the integration density of the component. Indeed, since the n-type contact pad is prepared around the n-type layer, the width and the upper surface area of the final component increase little.

Furthermore, if layer 140 is deposited both on the lateral walls of n-type layers 132 and in trenches 160 (on the bottom of the trenches or filling the volume of the trenches), it is possible to put directly in parallel several adjacent elemental structures and to thus again minimize the electrical resistance of the n-type contact common to several structures.

When the conductive material layer is not continuous between two elemental structures, as is the case when it is etched as indicated above, it is possible during the final wiring operation to connect several elemental structures in series.

Conductive material layer 141, here copper, is deposited on the whole of the plate so as to cover it with p-type contact pads 138 and n-type contact pads 145 (step S15, figure 1K). Conductive material layer 142 thus covers the whole of the elemental LED structures above contact pads 138 and fills trenches 160 thus connecting here n-type contact pads 145 of the adjacent elemental structures.

A bonding layer promoting semiconductor/metal adhesion, for example Ta and/or TaN, is preferably deposited on p-type contact pads 138 and n-type contact pads 145 before deposition of layer 141.

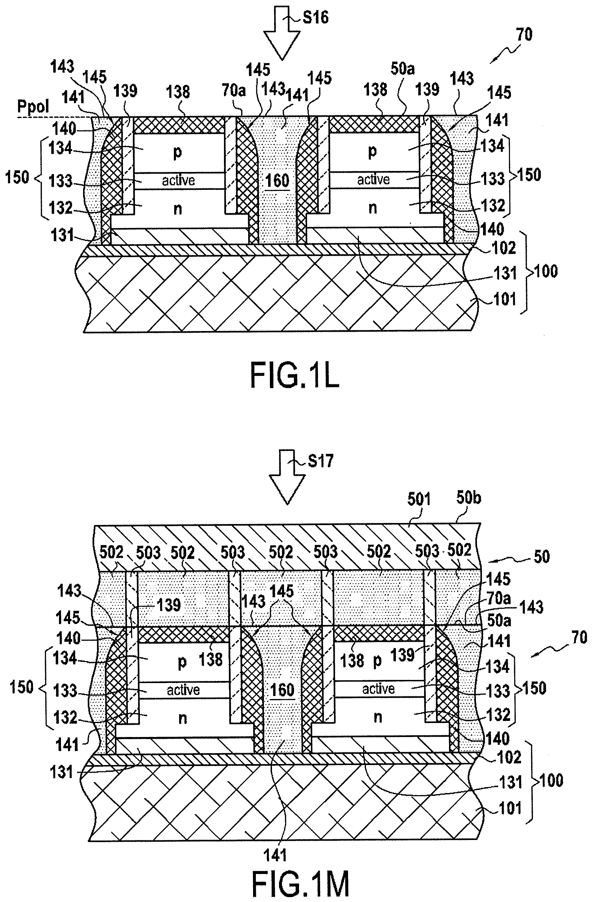

Conductive material layer 141 is polished by chemical-mechanical polishing (CMP) to depth Ppol (figure 1J) so as to expose p-type contact pads 138 and to form portions or n-type contact plugs 143 of conductive material layer 141 in contact with n-type contact pads 145 in order to allow contact on each of these pads (step S16, figure 1L). Contact pads 138 and 144 are separated from each other by insulating material layer 139. Polishing of conductive material layer 141, for example, is carried out until reaching at least the part of insulating material layer 139 present between p- 138 and n-type 145 electrical contact pads so as to form structure 70 comprising individual portions 143 of conductive material layer 141, each of these individual portions 143 being in contact with one or more n-type electrical contact pads 145.

At this stage of the process, one has structure 70 having planar surface 70a compatible with direct bonding on a final or receiver substrate.

In the example described here, the method continues with bonding by molecular adhesion of structure 70 with final or receiver substrate 50 (step S17, figure 1M). As is well-known in its own right, the principle of bonding by molecular adhesion, also called direct bonding, is based on the bringing of two surfaces (here surfaces 70a and 50a of structure 70 and substrate 50) into direct contact, i.e., without the use of a specific material (adhesive, wax, solder, etc.). Such an operation requires that the surfaces to be bonded are sufficiently smooth and free of particles or contamination and that they are brought sufficiently close to make it possible to initiate contact, typically at a distance of less than a few nanometers. In this case, the attractive forces between the two surfaces are great enough to cause molecular adhesion (bonding induced by the sum of the attractive forces (van der Waals forces) of the electron interactions between the atoms or molecules of the two surfaces to be bonded).

However, structure 70 and final substrate 50 can also be assembled by other types of bonding such as anodic bonding, metallic bonding, or with adhesive.

Final substrate 50 makes it possible to at least ensure good mechanical support for the final LED devices as well as access to the n- and p-type contact pads. In the example described at present, final substrate 50 is formed of a plate 501 which comprises on the side of the substrate's bonding surface 50a copper contact pads 502 insulated from each other by portions of insulating material 503, for example SiN. Each contact pad 502 was formed at a location in alignment with at least part of p-type contact pad 138 or part of n-type contact plug 143 exposed on planar surface 70a of structure 70 (figure 1M). Plate 501 can be composed notably of alumina, or of polycrystalline AlN, a good thermal conductor, or of silicon.

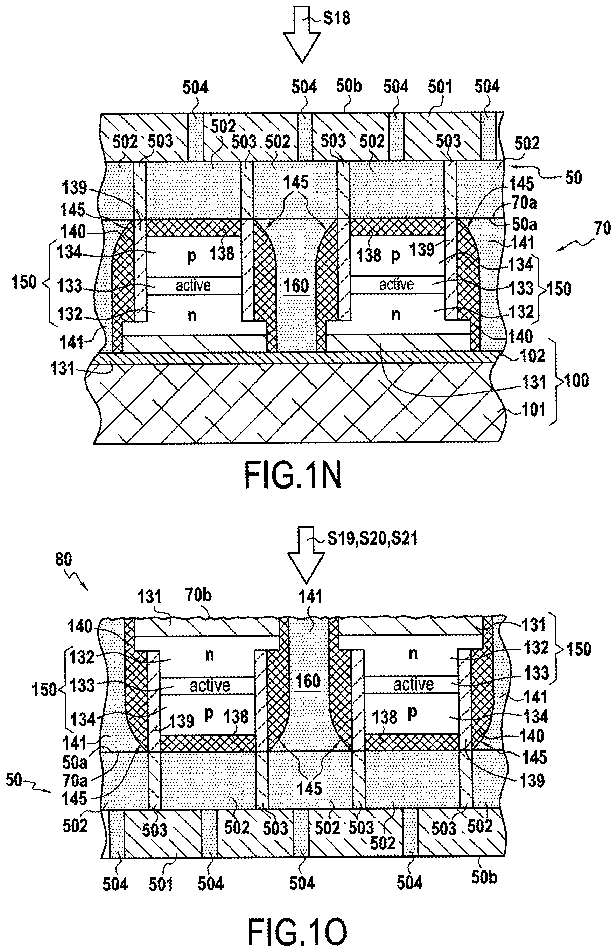

In this case, p-type contact pads 138 and n-type contact plugs 143 of structure 70 are accessed from surface 50b opposite bonding surface 50a of final substrate 50 by forming vertical electronic connections 504, also called vias, for example of copper, through plate 501, each of these vertical connections emerging at a contact pad 502 (step S18, figure 1N). In the case of a plate 501 of silicon, the internal surface of the vias will be insulated beforehand in accordance with the well-known through-silicon via (TSV) method. Electronic connections 504 and their optional internal insulation are prepared preferably before bonding final substrate 50.

According to a variant embodiment, the final substrate can be formed of a solid plate, for example silicon or AlN, on the bonding surface of which have been cut a plurality of cavities at locations in alignment with the parts exposed on planar surface 70a of structure 70 of p-type contact pads 138 and n-type contact plugs 143, the cavities being filled with a conductive material, for example copper. Once the final substrate is bonded to structure 70, the latter is thinned to uncover the conductive material present in the cavities so as to form vertical electrical connections each respectively in contact with a p-type contact pad 138 or n-type contact plug 143 and accessible by the back of the final substrate.

In the case where the final substrate material allows it, for example in the case where the final substrate is formed of a silicon plate or comprises a layer of silicon, electronic circuits intended to function with the LED devices can be formed beforehand and connected to p-type contact pads 138 and n-type contact plugs 143 by vertical electronic connections formed in the final substrate. Among the electronic circuits that can be envisaged, particular mention may be made of passive regulation devices (protection diode, resistance for ESD, condenser, etc.) and active regulation devices (current regulator).

The final substrate can also include electronic interconnection circuits allowing the preparation of LED devices comprising several elemental LED structures connected in series or in parallel.

According to another variant embodiment, surface 70a of structure 70 can be covered with a layer of SiO₂ planarized by chemical-mechanical polishing. The final substrate is in this case composed of a plate of virgin silicon or of insulating substrate (alumina or AlN, for example). If the bonding surface of the final substrate is too rough for bonding by molecular adhesion (typically >0.3 nm RMS for a 5×5 µm surface scan), a layer of SiO₂ can also be deposited and planarized. The two surfaces thus prepared are bonded together by molecular adhesion. Annealing can be carried out to strengthen the bond. The final substrate can be then thinned (to 100 µm, for example) to allow the preparation of vertical electrical connections or vias in contact with the p- and n-type contact pads of LEDs structure 70. With this variant embodiment, one is freed from the problems of alignment between the contact pads of the LEDs structure and the electrical connections or vias of the final substrate since the latter are prepared after bonding of the LEDs structure with the final substrate.

Once final substrate 50 and structure 70 are assembled, support substrate 101 is removed, for example, by the well-known laser lift-off technique, notably in the case of a sapphire substrate, or by chemical etching (step S19, figure 1O). In the particular case of an InGaN support substrate, its removal by laser lift-off can be adapted by inserting layers facilitating detachment of the substrate by this technique. In the case of removal by chemical etching, barrier layers can also be inserted to preserve the remainder of the LEDs structure. In the case of removal by laser lift-off or another nondestructive technique, the support substrate can be reused.

After removal of support substrate 101, carried out here by laser lift-off, buried layer 102 and growth islands 131 are removed, for example by chemical etching (step S20, figure 1O).

One obtains, at this stage of the process, structure 80 from which can be cut out LED devices each formed of one or more elemental structures wired and provided with a substrate equipped with n- and p-type connections disposed on one surface of the latter.

Still collectively, uncovered rear surface 70b of LEDs structure 70 can be etched in order to remove any residues remaining from support substrate 101, buried layer 102, or growth islands 131 and can be structured to increase the extraction of light therefrom (step S21, figure 1O). Etching can be carried out notably by reactive plasma etching (chlorinated or fluorinated) or by UV-assisted chemical (PEC) etching.

In the case of formation of white-light LED devices, a layer of luminophoric material capable of converting light emitted by the devices into white light can be deposited on surface 70b of LEDs structure 70, for example by applying a liquid phosphorus-based composition to surface 70b of structure 70 followed by annealing to evaporate the dispersion solvent (spin-on glass).

Furthermore, the LED devices can be provided with microstructures such as Fresnel lenses, for example by nano- or micro-printing microstructures on surface 70b of structure 70.

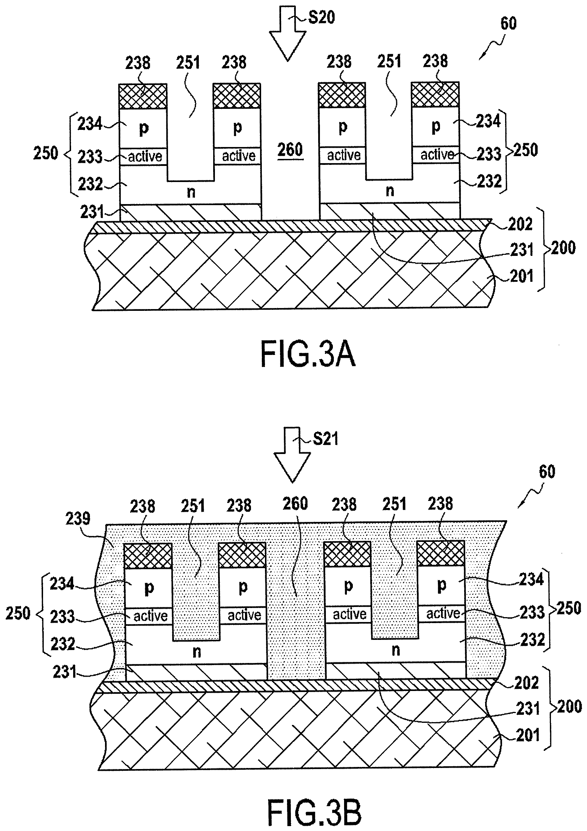

According to a variant embodiment of the inventive method, n-type contact pads are formed inside the elemental LED structures. This variant embodiment is implemented from a structure 60 identical to structure 30 presented in figure 1F and obtained after steps S1 to S9 described above. More precisely, as illustrated in figure 3A, structure 60 comprises as described above a plate or composite growth substrate 200 comprising a support substrate 201, buried layer 202 and growth islands 231 separated by trenches 260 and on which have been prepared elemental structures 250 comprising an n-type layer 232, active layer 233 and p-type layer 234. p-type contact pads 238 were further formed on p-type layers 234 as described above.

In accordance with this variant embodiment, a central opening 251 is made in each elemental structure 250 from p-type contact pad 138 through to n-type layer 232 (step S20, figure 3A). Openings 251 can notably be prepared by chemical etching or dry etching, for example reactive-ion etching (RIE).

Insulating material layer 239, for example SiO₂, is deposited by plasma-enhanced chemical vapor deposition (PECVD) on the whole of the upper surface of structure 200 comprising elemental structures 250, layer 239 covering both elemental structures 250 and trenches 260 (step S21, figure 3B).

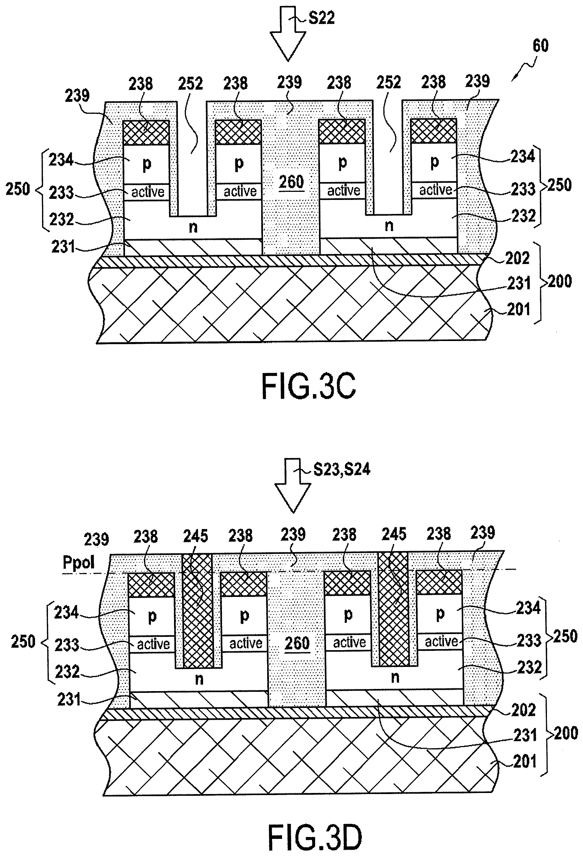

Layer 239 is then opened, for example by dry or wet selective chemical etching, so as to create central openings 252 of the same depth as openings 251 but over a narrower width than the latter (step S22, figure 3C). To this end, use is made of an etching mask comprising a protective resin layer with openings delimiting the zones to be etched in the structure, here openings 252. Openings 252 being narrower than openings 251, a portion of insulating material layer 239 remains on the sides of the p-type contact pads and of layers 234, 233 and 232 exposed in openings 251 (figure 3C).

n-type contact pads 245 are formed in openings 252 by deposition in the latter of at least one conductive material, for example Ti/Al/Ni, that is in contact with n-type layer 232 exposed at the bottom of openings 252 (step S23, figure 3D). During deposition of materials for n-type contact pads 245, the mask used is preserved for etching openings 252. Once contact pads 245 are formed, the protective resin of the etching mask is removed, which makes it possible to remove at the same time the constitutive materials of n-type contact pads 245 deposited beyond openings 252 (step S24, figure 3D).

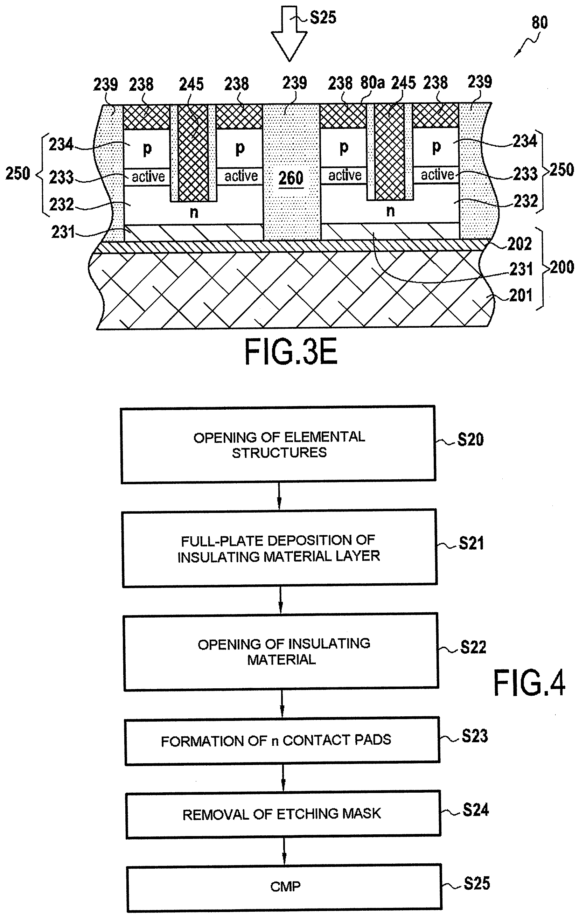

Insulating material layer 239 and n-type contact pads 245 are polished by chemical-mechanical polishing (CMP) to depth Ppol (figure 3D) so as to expose p-type contact pads 238 and n-type contact pads 245 in order to allow a contact plug on each of these pads (step S25, figure 3E). Contact pads 238 and 245 are separated from each other by insulating material layer 239.

At this stage of the process, one has structure 80 with planar surface 80a compatible with direct bonding with a final or receiver substrate.

The method then continues in the same way as described above, i.e., by repeating steps S17 to S20 described above in reference to figures 1M to 1O.

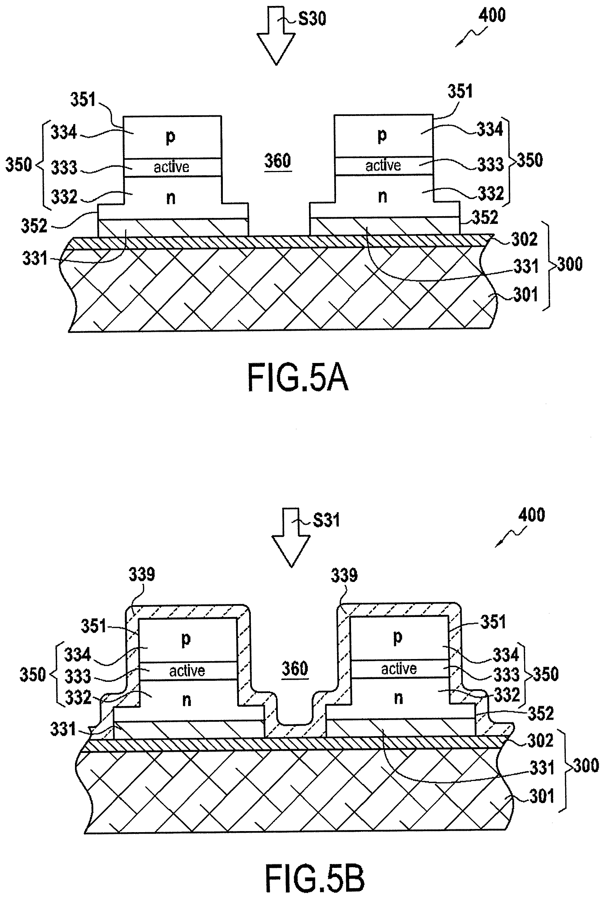

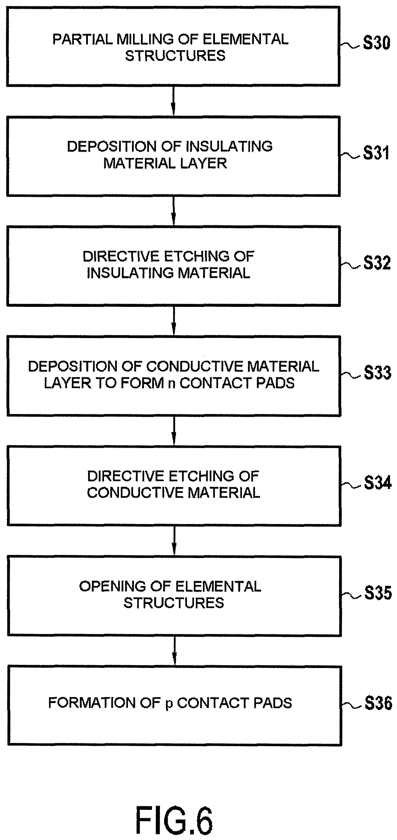

According to another variant embodiment of the inventive method described in reference to figures 5A to 5E and 6, p-type contact pads are formed after n-type contact pads. This variant embodiment is implemented from a structure 400 identical to the structure presented in figure 1G but without p-type contact pads, structure 400 being obtained after steps forming elemental structures 350 separated by trenches 360 and comprising n-type layer 332, active layer 333 and p-type layer 334 prepared under the same conditions as steps S1, S2 and S3 described above and after a milling step carried out under same the conditions as step S10 described above. Milling, for example, is carried out by chemical etching or dry etching of a lateral portion of elemental structures 350 over a determined width and to a determined depth in n-type layer 332 so as to form in each elemental structure 350, on the one hand, milled portion 351 having reduced lateral dimensions and comprising layers 334 and 333 as well as part of layer 332, and, on the other hand, a underlying portion 352 comprising the remainder of unmilled layer 332 (step S30, figure 5A).

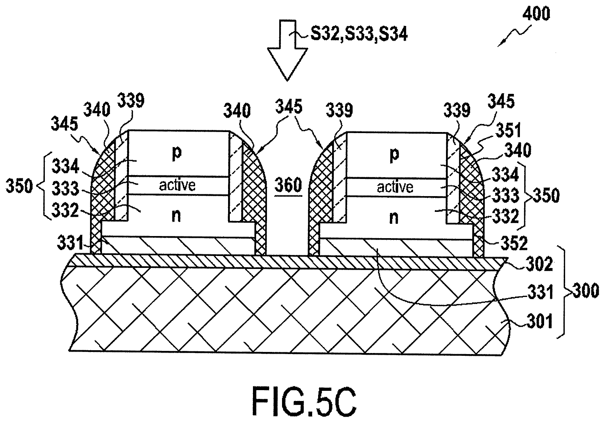

After milling, one proceeds to full-plate deposition of thin insulating material layer 339, for example SiO₂ (step S31, figure 5B) such as, for example, described above in reference to step S11. This deposition is followed by directive dry etching (similar to step S12 described above) that preferentially etches in the vertical direction so as to open insulating material layer 339 on the surface of p-type contact pads 338 and n-type layer 332 present on unmilled portion 352. After dry etching, layer 339 remains only on the sides of elemental structures 350 on milled portion 351 (step S32, figure 5C).

One then carries out deposition of conductive material layer 340, for example Ti/Al/Ni, followed by directive dry etching that preferentially etches in the vertical direction so as to leave layer 340 remaining on the lateral walls of elemental structures 150 (steps S33 and S34, figure 5C). These steps S33 and S34 are carried out under the same conditions as steps S13 and S14, respectively. Conductive material layer 340 is in contact with the lateral wall of n-type layer 332 present on unmilled portion 352 of elemental structures 350 and is capable of forming n-type contact pads 345.

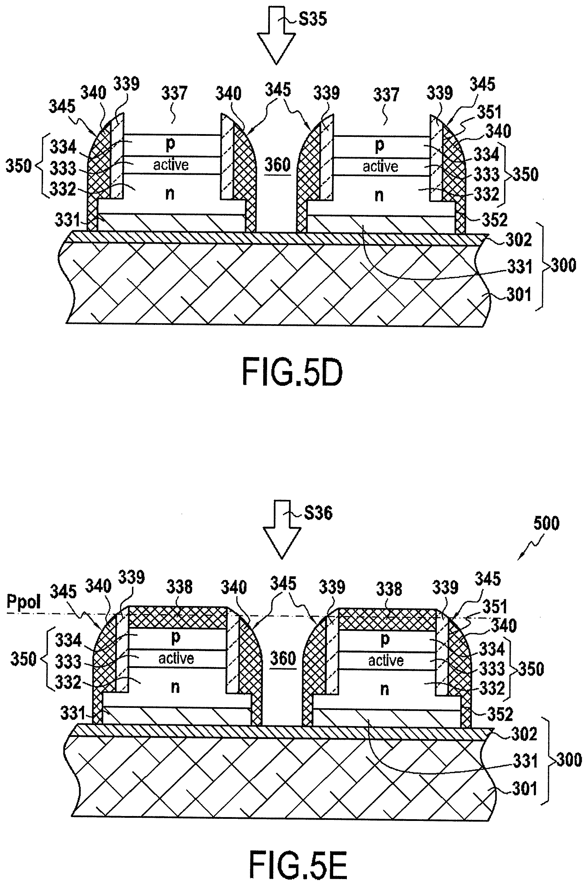

P-type layers 334 are then opened, for example by dry or wet selective chemical etching, over a limited depth (step S35, figure 5D). To this end, use is made of an etching mask comprising a protective resin layer with openings delimiting the zones to be etched in the structure, namely openings 337.

p-type contact pads 338 are formed in openings 337 by deposition in the latter of at least one conductive material (step S36, figure 5E). During deposition of the materials for contact pads 338, the mask used is preserved for etching openings 337. Once p-type contact pads 338 are formed, the protective resin of the etching mask is removed, which makes it possible to remove at the same time the constitutive materials of p-type contact pads 338 deposited beyond openings 337.

At this stage of the process, one has structure 500 in the form of a plate with a plurality of elemental structures 350 each provided with a p-type contact pad and an n-type contact pad, structure 500 being able to be cut out in a plurality of devices each comprising one or more elemental structures 350 according to the final application envisaged, the remaining LED formation operations being carried out individually for each device cut out.

The method then continues in the same way as described above, i.e., by repeating steps S15 to S21 described above in reference to figures 1K to 1O.

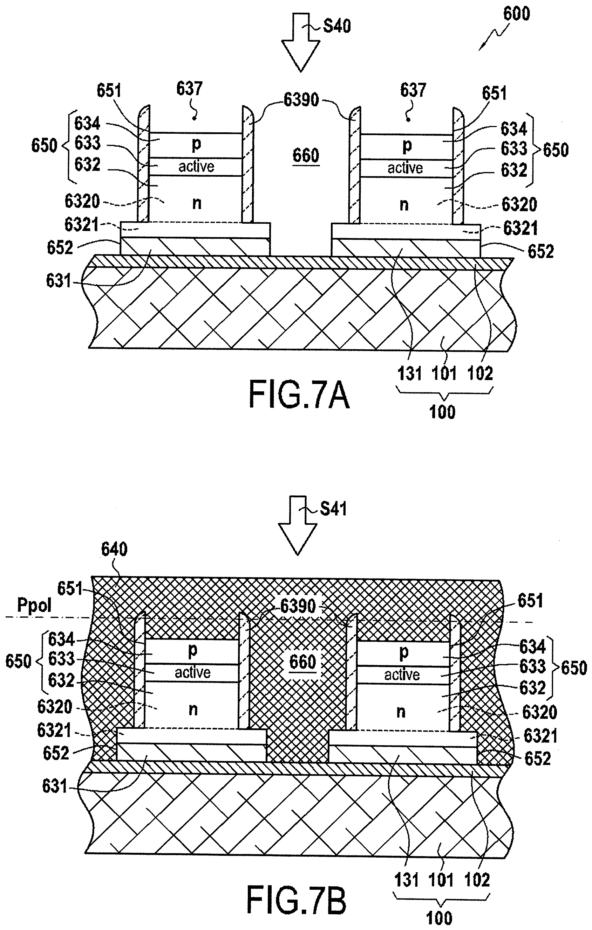

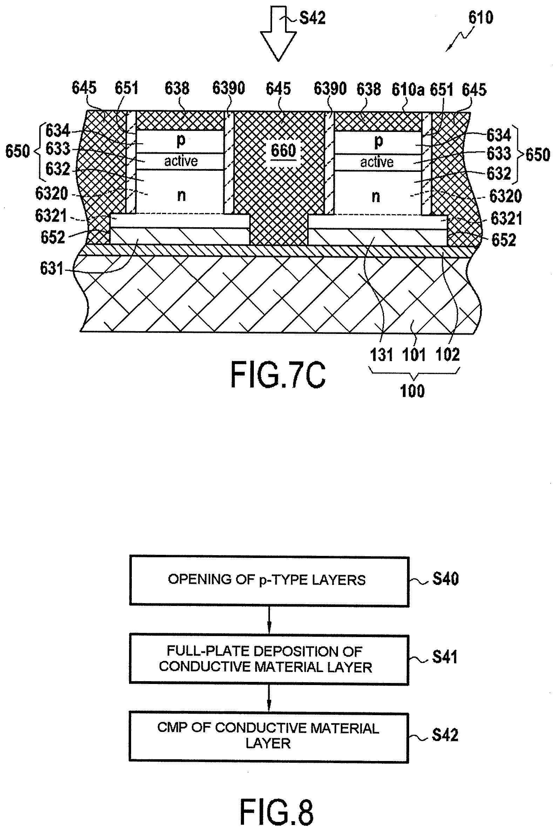

According to another variant embodiment of the inventive method described in reference to figures 7A to 7C and 8, the n- and p-type contact pads are formed simultaneously. This variant embodiment is implemented from a structure 600 identical to the structure described above at the conclusion of step S32, i.e., after:
- steps forming elemental LED structures 650 separated by trenches 660 and comprising n-type layer 632, active layer 633 and p-type layer 634 carried out under the same conditions as steps S1, S2 and S3 described above,
- a step carried out under the same conditions as step S10 described above and making it possible to form in each elemental LED structure 650 a first portion 651 comprising p-type layer 634, active layer 633 and a first part 6320 of the n-type layer in contact with active layer 633 and having reduced lateral dimensions (width, diameter, etc.) in relation to a second underlying portion 652 comprising second part 6321 of unmilled n-type layer 632,
- a step similar to step S11 described above of full-plate deposition of an insulating material layer, for example SiO₂, having a limited thickness so as to follow the contours of elemental LED structures 650 and trenches 660, and
- a step similar to step S12 described above of directive dry etching that preferentially etches in the vertical direction so as to leave remaining only portion 6390 of the insulating material layer on the sides of elemental structures 650 on first portion 651 of reduced lateral dimensions.

In this variant embodiment, p-type layers 634 are then opened, for example by dry or wet selective chemical etching, to a determined depth (step S40, figure 7A). To this end, use is made of an etching mask comprising a protective resin layer with openings delimiting the zones to be etched in the structure, here openings 637.

One then carries out full-plate deposition of conductive material layer 640 which covers the whole of elemental structures 650 and trenches 660 while filling openings 637 (step S41, figure 7B).

Conductive material layer 640 is polished by chemical-mechanical polishing (CMP) to depth Ppol (figure 7B) so as to form p-type contact pads 638 and n-type contact pads 645 separated from each other by portions 6390 of insulating material (step S42, figure 7C).

At this stage of the process, one has structure 610 in the form of a plate with a plurality of elemental structures 650 each provided with a p-type contact pad and an n-type contact pad, structure 610 having planar surface 610a compatible with bonding by molecular adhesion on a final or receiver substrate.

## Claims

1. Method of collective manufacturing of light-emitting diode (LED) devices comprising formation on a surface of a first substrate (100) of a plurality of elemental LED structures (150) each comprising at least one n-type layer (132; 332), an active layer (133; 333) and a p-type layer (134; 334), the elemental LED structures (150; 350) being spaced apart from each other on the first substrate by trenches (160; 360), the method further comprising:
- reduction of the lateral dimensions of the p-type layer (134), the active layer (133) and a first part (1320) of the n-type layer (132) in contact with the active layer, the n-type layer (132) having a second part (1321) with lateral dimensions larger than said first part (1320) of the n-type layer;
- deposition of an insulating material layer (139; 339) on at least each elemental structure (150; 350);
- formation of a portion of insulating material (139) on the sides of the p-type layer (134), the active layer (133) and the first part (1320) of the n-type layer (132);
- formation of n-type electrical contact pads (145) on at least the whole of the second part (1321) of the exposed n-type layer (132);
- formation of p-type electrical contact pads (138) before or after said lateral dimension reduction step; the method being **characterized in that** it further comprises:
- deposition of a conductive material layer (141) on the whole of the surface of the first substrate (100) comprising the elemental LED structures (150) and polishing said conductive material layer (141), said polishing being carried out until reaching at least the part of the insulating material layer (139) present between the p- and n-type electrical contact pads (138, 145) so as to form a structure (70) comprising individual portions (143) of the conductive material layer (141), each individual portion (143) being in contact with one or more n-type electrical contact pads (145); and
- bonding by molecular adhesion of a second substrate (50) on the polished surface (70a) of said structure (70).

2. The method according to claim 1, **characterized in that** the insulating material layer is further deposited in part of the trenches (160; 360) present between the elemental LED structures (150; 350), the trenches free of insulating material delimiting cutting zones around the elemental LED structures.

3. The method according to claim 1 or 2, **characterized in that** each elemental LED structure (150; 350) is formed on an island (131; 231; 331) of relaxed or partially relaxed material.

4. The method according to claim 3, **characterized in that** the relaxed or partially relaxed material is InGaN.

5. The method according to any one of claims 1 to 4, **characterized in that** it comprises, after the bonding of the second substrate (50), removal of the first substrate (100).

6. The method according to claim 5, **characterized in that** it comprises deposition of a light-converting material layer on the surface (70b) of the elemental LED structures (150) exposed after removal of the first substrate (100).

7. The method according to claim 5 or 6, **characterized in that** it comprises formation of microstructures on the surface (70b) of the elemental LED structures (150) exposed after removal of the first substrate (100).

8. The method according to any one of claims 1 to 7, **characterized in that** the second substrate (50) comprises on its bonding surface (50a) a plurality of electrical contact pads (502) disposed at positions in alignment with the individual portions (143) of the conductive material layer (141) or with the p-type contact pads (138).

9. The method according to any one of claims 1 to 8, **characterized in that** formation of the n-type contact pads (145) comprises deposition of a conductive material layer (140) of determined thickness on the whole of the surface of the first substrate (100) comprising the elemental LED structures (150).

10. The method according to claim 9, **characterized in that** it further comprises, after deposition of the conductive material layer (140), directive etching of said conductive material layer so as to leave remaining portions of the conductive material layer (140) on the lateral walls of the elemental structures (150), said portions forming the n-type contact pads (145).

11. The method according to claim 10, **characterized in that** it comprises, after the selective etching step, formation of openings (137) to a limited depth in the p-type layer (134) of each elemental LED structure (150) and filling of these openings with a conductive material so as to form a p-type contact pad (138).

## Patentansprüche

1. Verfahren zur kollektiven Herstellung von Leuchtdioden (LED)-Vorrichtungen, umfassend die Bildung eines ersten Substrats (100) einer Vielzahl von elementaren LED-Strukturen (150) auf einer Fläche, wobei jede wenigstens eine Schicht vom n-Typ (132; 332), eine aktive Schicht (133; 333) und eine Schicht vom p-Typ (134; 334) umfasst, wobei die elementaren LED-Strukturen (150; 350) auf dem ersten Substrat durch Rinnen (160; 360) voneinander beabstandet sind, wobei das Verfahren weiterhin umfasst:
- die Reduzierung der lateralen Abmessung der Schicht vom p-Typ (134), der aktiven Schicht (133) und eines ersten Teils (1320) der Schicht vom n-Typ (132) im Kontakt mit der aktiven Schicht, wobei die Schicht vom n-Typ (132) einen zweiten Teil (1321) mit lateralen Abmessungen hat, die breiter sind als der genannte erste Teil (1320) der Schicht vom n-Typ;
- die Ablagerung einer isolierenden Materialschicht (139; 339) auf wenigstens einer elementaren Struktur (150; 350);
- die Bildung eines Abschnitts insolierenden Materials (139) auf den Seiten der Schicht vom p-Typ (134), der aktiven Schicht (133) und des ersten Teils (1320) der Schicht vom n-Typ (132);
- die Bildung von elektrischen Kontaktblöcken (145) vom n-Typ auf wenigstens dem gesamten zweiten Teil (1321) der freigelegten Schicht vom n-Typ (132);
- die Bildung von elektrischen Kontaktblöcken (138) vom p-Typ vor oder nach dem genannten lateralen Abmessungsreduzierungsschritt;
wobei das Verfahren **dadurch gekennzeichnet ist, dass** es weiterhin umfasst:
- das Aufbringen einer leitenden Materialschicht (141) auf der gesamten Fläche des ersten Substrats (100), umfassend die elementaren LED-Strukturen (150) und das Polieren der genannten leitenden Materialschicht (141), wobei das genannte Polieren ausgeführt wird, bis wenigstens der Teil der isolierenden Materialschicht (139) realisiert ist, die zwischen den elektrischen Kontaktblöcken (138, 145) vom p- und vom n-Typ derart erreicht werden, dass eine Struktur (70) gebildet wird, die einzelne Abschnitte (143) der leitenden Materialschicht (141) umfasst, wobei jeder einzelne Abschnitt (143) mit einem oder mehreren elektrischen Kontaktblock / Kontaktblöcken (145) vom n-Typ in Kontakt ist; und
- das Verkleben durch molekulare Adhäsion eines zweiten Substrats (50) auf der polierten Fläche (70a) der genannten Struktur (70).

2. Verfahren gemäß Anspruch 1, **dadurch gekennzeichnet, dass** die isolierende Materialschicht weiterhin teilweise in den Rillen (160; 360) aufgebracht ist, die zwischen den elementaren LED-Strukturen (150; 350) vorhanden sind, wobei die von isolierendem Material freien Rillen Schneidbereiche um die elementaren LED-Strukturen begrenzen.

3. Verfahren gemäß Anspruch 1 oder 2, **dadurch gekennzeichnet, dass** jede elementare LED-Struktur (150; 350) auf einer Insel (131; 231; 331) des entspannten oder teilweise entspannten Materials gebildet ist.

4. Verfahren gemäß Anspruch 3, **dadurch gekennzeichnet, dass** das entspannte oder teilweise entspannte Material InGaN ist.

5. Verfahren gemäß irgendeinem der Ansprüche 1 bis 4, **dadurch gekennzeichnet, dass** es nach dem Verkleben des zweiten Substrats (50) die Entfernung des ersten Substrats (100) umfasst.

6. Verfahren gemäß Anspruch 5, **dadurch gekennzeichnet, dass** es das Aufbringen einer Licht konvertierenden Materialschicht auf die Fläche (70b) der freigelegten elementaren LED-Strukturen (150) nach der Entfernung des ersten Substrats (100) umfasst.

7. Verfahren gemäß Anspruch 5 oder 6, **dadurch gekennzeichnet, dass** es die Bildung von Mikrostrukturen auf der Fläche (70b) der freigelegten elementaren Strukturen (150b) nach der Entfernung des ersten Substrats (100) umfasst.

8. Verfahren gemäß irgendeinem der Ansprüche 1 bis 7, **dadurch gekennzeichnet, dass** das zweite Substrat (50) auf seiner Verklebungsfläche (50a) eine Vielzahl von elektrischen Kontaktklötzen (502) umfasst, die in Positionen in Fluchtung mit den einzelnen Abschnitten (143) der leitenden Materialschicht (141) oder mit den Kontaktklötzen (138) vom p-Typ angeordnet sind.

9. Verfahren gemäß irgendeinem der Ansprüche 1 bis 8, **dadurch gekennzeichnet, dass** die Bildung der Kontaktklötze (145) vom n-Typ das Aufbringen einer leitenden Materialschicht (140) einer bestimmten Dicke auf der gesamten Fläche des ersten Substrats (100) umfasst, das die elementaren LED-Strukturen (150) umfasst.

10. Verfahren gemäß Anspruch 9, **dadurch gekennzeichnet, dass** es nach dem Aufbringen der leitenden Materialschicht (140) weiterhin ein gerichtetes Ätzen der genannten Materialschicht derart umfasst, dass verbleibende Abschnitte der leitenden Materialschicht (140) auf den Seitenwänden der elementaren Strukturen (150) belassen werden, wobei die genannten Abschnitte die Kontaktklötze (145) vom n-Typ bilden.

11. Verfahren gemäß Anspruch 10, **dadurch gekennzeichnet, dass** es nach dem selektiven Ätzschritt die Bildung von Öffnungen (137) zu einer begrenzten Tiefe in der Schicht (134) vom n-Typ jeder elementaren LED-Struktur (150) und das Füllen dieser Öffnungen mit einem leitenden Material derart umfasst, dass ein Kontaktklotz (138) vom p-Typ gebildet wird.

## Revendications

1. Procédé de fabrication collective de dispositifs à diodes électroluminescentes (DEL) comprenant la formation sur une surface d'un premier substrat (100) d'une pluralité de structures élémentaires de DEL (150) comprenant chacune au moins une couche de type n (132 ; 332), une couche active (133 ; 333) et une couche de type p (134 ; 334), les structures élémentaires de DEL (150 ; 350) étant espacées les unes des autres sur le premier substrat par des rigoles (160 ; 360), le procédé comprenant en outre :
- la réduction des dimensions latérales de la couche de type p (134), de la couche active (133) et d'une première partie (1320) de la couche de type n (132) en contact avec la couche active, la couche de type n (132) ayant une seconde partie (1321) dont les dimensions latérales sont supérieures à celles de ladite première partie (1320) de la couche de type n ;
- le dépôt d'une couche de matériau isolant (139 ; 339) sur au moins chaque structure élémentaire (150 ; 350)
- la formation d'une portion de matériau isolant (139) sur les côtés de la couche de type p (134), de la couche active (133) et de la première partie (1320) de la couche de type n (132) ;
- la formation de plages de contact électrique de type n (145) sur au moins la totalité de la seconde partie (1321) de la couche de type n (132) exposée ;
- la formation de plages de contact électrique de type p (138) avant ou après ladite étape de réduction des dimensions latérales ;
le procédé étant **caractérisé en ce qu'**il comprend en outre :
- le dépôt d'une couche de matériau conducteur (141) sur l'intégralité de la surface du premier substrat (100) comprenant les structures élémentaires de DEL (150) et le polissage de ladite couche de matériau conducteur (141), ledit polissage étant réalisé jusqu'à atteindre au moins la partie de la couche de matériau isolant (139) présente entre les plages de contact électrique de type p et de type n (138, 145) de façon à former une structure (70) comprenant des portions individuelles (143) de la couche de matériau conducteur (141), chaque portion individuelle (143) étant en contact avec une ou plusieurs des plages de contact électrique de type n (145) ; et
- le collage par adhérence moléculaire d'un second substrat (50) sur la surface polie (70a) de ladite structure (70).

2. Procédé selon la revendication 1, **caractérisé en ce que** la couche de matériau isolant est en outre déposée dans une partie des rigoles (160 ; 360) présentes entre les structures élémentaires de DEL (150 ; 350), les rigoles exemptes de matériau isolant délimitant des zones de découpe autour des structures élémentaires de DEL.

3. Procédé selon la revendication 1 ou 2, **caractérisé en ce que** chaque structure élémentaire de DEL (150 ; 350) est formée sur un îlot (131 ; 231 ; 331) de matériau assoupli ou partiellement assoupli.

4. Procédé selon la revendication 3, **caractérisé en ce que** le matériau assoupli ou partiellement assoupli est InGaN.

5. Procédé selon l'une quelconque des revendications 1 à 4, **caractérisé en ce qu'**il comprend, après le collage du second substrat (50), le retrait du premier substrat (100).

6. Procédé selon la revendication 5, **caractérisé en ce qu'**il comprend le dépôt d'une couche de matériau de conversion lumineuse sur la surface (70b) des structures élémentaires de DEL (150) exposées après le retrait du premier substrat (100).

7. Procédé selon la revendication 5 ou 6, **caractérisé en ce qu'**il comprend la formation de microstructures sur la surface (70b) des structures élémentaires de DEL (150) exposées après le retrait du premier substrat (100).

8. Procédé selon l'une quelconque des revendications 1 à 7, **caractérisé en ce que** le second substrat (50) comprend, sur sa surface de collage (50a), une pluralité de plages de contact électrique (502) placées dans des positions alignées avec les portions individuelles (143) de la couche de matériau conducteur (141) ou avec les plages de contact électrique de type p (138).

9. Procédé selon l'une quelconque des revendications 1 à 8, **caractérisé en ce que** la formation des plages de contact électrique de type n (145) comprend le dépôt d'une couche de matériau conducteur (140) d'épaisseur déterminée sur l'intégralité de la surface du premier substrat (100) comprenant les structures élémentaires de DEL (150).

10. Procédé selon la revendication 9, **caractérisé en ce qu'**il comprend en outre, après le dépôt de la couche de matériau conducteur (140), la gravure directive de ladite couche de matériau conducteur de façon à laisser des portions restantes de la couche de matériau conducteur (140) sur les parois latérales des structures élémentaires (150), lesdites portions formant les plages de contact électrique de type n (145).

11. Procédé selon la revendication 10, **caractérisé en ce qu'**il comprend, après l'étape de gravure sélective, la formation de lumières (137) jusqu'à une profondeur limitée dans la couche de type p (134) de chaque structure élémentaire de DEL (150) et le remplissage desdites lumières avec un matériau conducteur de façon à former une plage de contact de type p (138).
